# EUROPEAN PATENT APPLICATION

(11) **EP 1 378 951 A2**
(43) Date of publication of application: **07.01.2004**
(21) Application number: 03015175.7
(22) Date of filing: 03.07.2003
(51) Int. Cl.: H01L 51/20, G02F 1/13357, H05B 33/04

(54) **Lighting system and display**

(30) Priority: 05.07.2002 JP 2002197739; 26.09.2002 JP 2002281620
(71) Applicant: KABUSHIKI KAISHA TOYOTA JIDOSHOKKI, Kariya-shi, Aichi-ken (JP)
(72) Inventor: Kato, Yoshifumi, Kariya-shi, Aichi-ken (JP); Noritake, Kazuto, Kariya-shi, Aichi-ken (JP)
(74) Representative: Leson, Thomas Johannes Alois, Dipl.-Ing.

(57) **Abstract**

A lighting system and a display prevent moisture from entering a light emitting element. The lighting system and a display of the present invention include an electroluminescent layer located between a first electrode and a second electrode. The electroluminescent layer functions as a light emitting element. A passivation film is located on the first electrode. The passivation film blocks moisture thereby sealing the electroluminescent layer.

## Description

### BACKGROUND OF THE INVENTION

The present invention relates to a lighting system and a display equipped with the lighting system.

Japanese Laid-Open Patent Publication No. 10-78582 discloses a display having an organic electroluminescent panel and a liquid crystal panel. The electroluminescent panel functions as a backlighting system. The liquid crystal panel uses light emitted by the electroluminescent panel to show an image. The electroluminescent panel includes an electroluminescent layer functioning as a light emitting element located between a transparent electrode that is of a light transmittance type and a light reflecting electrode. The electroluminescent layer includes an organic electroluminescent material. Light that is emitted from the electroluminescent layer passes through the transmittance type electrode. Then, the light is directed to the liquid crystal panel.

To prevent attenuation of light while light emitted by the electroluminescent layer is passing through the transparent electrode, the transparent electrode is preferably as thin as possible. The transparent electrode is therefore formed through deposition or sputtering. However, a transparent electrode formed through deposition or sputtering often has pinholes. Pinholes in a transparent electrode permit moisture to enter the electroluminescent layer, which in turn degrades the electroluminescent layer.

In the display disclosed in the above publication, the liquid crystal panel is located on the transparent electrode. However, even in this case, it is difficult to completely remove outside air from a portion of the display between the electroluminescent panel and the liquid crystal panel during manufacture. Thus, moisture contained in the outside air is likely to enter the electroluminescent layer through the pinholes.

### SUMMARY OF THE INVENTION

Accordingly, it is an objective of the present invention to provide a lighting system and a display that prevent moisture from entering a light emitting element.

To achieve the foregoing and other objectives and in accordance with the purpose of the present invention, a lighting system having a substrate, a light emitting element, a first electrode, a second electrode, a passivation film, and a light outputting surface is provided. The light emitting element is located on the substrate. The light emitting element has a first surface and a second surface. The first and second surfaces are on opposite sides of the light emitting element. The second surface faces the substrate. The light emitting element contains an electroluminescent material. The first electrode is located on the first surface, and is of a light transmittance type. The second electrode is located on the second surface. When a voltage is applied across the first electrode and the second electrode, the entire light emitting element emits light. The passivation film is located on the first electrode. The passivation film is of a light transmittance type, and covers the entire surface of the first electrode that faces away from the light emitting element. A light outputting surface is located on the passivation film. Light emitted by the light emitting element is outputted from the light outputting surface.

The present invention also provides a display having a backlighting unit and a display unit. The backlighting unit includes a substrate, a light emitting element, a first electrode, a second electrode, a passivation film, and a light outputting surface. The light emitting element is located on the substrate, and has a first surface and a second surface. The first and second surfaces are on opposite sides of the light emitting element. The second surface faces the substrate. The light emitting element contains an electroluminescent material. The first electrode is located on the first surface, and is of a light transmittance type. The second electrode is located on the second surface. When a voltage is applied across the first electrode and the second electrode, the entire light emitting element emits light. The passivation film is located on the first electrode. The passivation film is of a light transmittance type, and covers the entire surface of the first electrode that faces away from the light emitting element. The light outputting surface is located on the passivation film. Light emitted by the light emitting element is outputted from the light outputting surface. The display unit is located on the backlighting unit, and displays an image by using light outputted from the light outputting surface.

Other aspects and advantages of the invention will become apparent from the following description, taken in conjunction with the accompanying drawings, illustrating by way of example the principles of the invention.

### BRIEF DESCRIPTION OF THE DRAWINGS

The invention,.together with objects and advantages thereof, may best be understood by reference to the following description of the presently preferred embodiments together with the accompanying drawings in which:
Fig. 1 is a schematic exploded perspective view showing a section of the display according to one embodiment of the present invention; and
Fig. 2 is a schematic cross-sectional view showing the backlight panel of the display shown in Fig. 1.

### DETAILED DESCRIPTION OF THE PREFERRED EMBODIMENTS

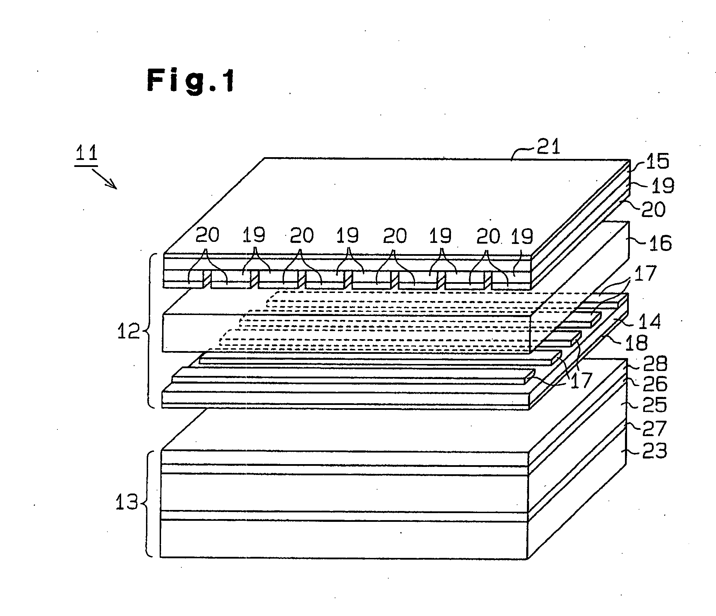

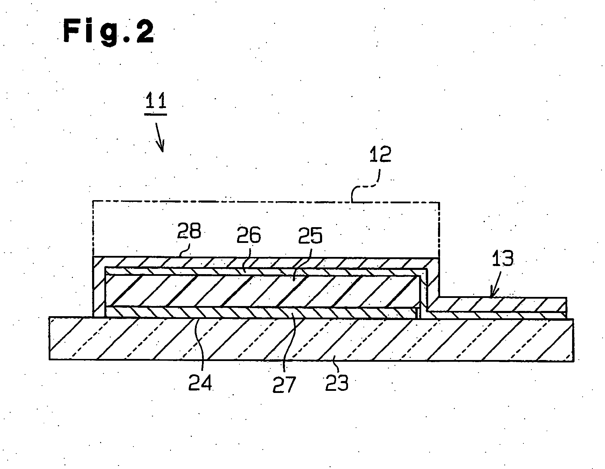

One embodiment according to a present invention will now be described with reference to Figs. 1 and 2. For convenience of illustration, the ratio of thicknesses of members in a display 11 is different from the actual ratio.

As shown in Fig. 1, the display 11 includes a transmissive liquid crystal panel 12 and a backlight panel 13. The liquid crystal panel 12 functions as a display unit, and the backlight panel 13 functions as a lighting unit.

The liquid crystal panel 12 includes liquid crystal elements, which are driven by a passive matrix system. The surface of the liquid crystal panel 12 that is facing away from the backlight panel 13 functions as a screen for displaying an image. The liquid crystal panel 12 has a pair of transparent substrates 14, 15, a liquid crystal 16, two sets of transparent electrodes 17, 20, a pair of polarizing plates 18, 21, and color filters 19.

The transparent substrates 14, 15 are of a light transmittance type and can be made of glass. The transparent substrate 14 is closer to the backlight panel 13 than the transparent substrate 15. The peripheral portions of the transparent substrates 14, 15 are bonded together with a sealing material (not shown).

The liquid crystal 16 is located between the transparent substrates 14 and 15. The transparent electrodes 17 are located on a surface of the transparent substrate 14 that faces the liquid crystal 16. The transparent electrodes 17 extend parallel to each other. The transparent electrodes 17 are of a light transmittance type and can be made of indium tin oxide. The polarizing plate 18 is located on a surface of the transparent substrate 14 that is facing away from the liquid crystal 16.

The color filters 19 are located on a surface of the transparent substrate 15 that faces the liquid crystal 16. The color filters 19 extend parallel to each other and perpendicular to a direction in which the transparent electrodes 17 extend. Each transparent electrode 20 is located on a surface of the corresponding color filter 19 that faces the liquid crystal 16. The transparent electrodes 20 extend parallel to each other and perpendicular to a direction in which the transparent electrodes 17 extend. The transparent electrodes 20 are of a light transmittance type and can be made of indium tin oxide. The polarizing plate 21 is located on a surface of the transparent substrate 15 that is facing away from the liquid crystal 16.

Portions of the liquid crystal 16 located between the transparent electrodes 17, 20, in other words, portions of the liquid crystal 16 corresponding to intersections between the transparent electrodes 17, 20, function as the liquid crystal elements. The arrangement of liquid crystal molecules of each liquid crystal element reversibly varies in accordance with an electric field that is applied on the liquid crystal element. That is, the arrangement of the liquid crystal molecules of each liquid crystal element varies to prevent light from being transmitted when the electric field that is applied on the liquid crystal element is greater than or equal to a predetermined value, and varies to permit light to be transmitted when the electric field that is applied on the liquid crystal element is less than the predetermined value. Each liquid crystal element is exposed to an electric field when voltage is applied to the corresponding transparent electrodes 17, 20 by a drive apparatus, which is not shown.

The backlight panel 13 shown in Figs. 1 and 2 is located behind the liquid crystal panel 12. The backlight panel 13 includes an organic electroluminescent element functioning as a light emitting element. The surface of the backlight panel 13 that faces the liquid crystal panel 12 functions as a light outputting surface that outputs light toward the liquid crystal panel 12. The backlight panel 13 includes a substrate 23, an electroluminescent layer 25, a first electrode 26, a second electrode 27, and a passivation film 28. The backlight panel 13 is an electroluminescent panel of the "top emission type".

The second electrode 27 is located on a surface of the substrate 23 that faces the liquid crystal panel 12 and functions as an anode. The electroluminescent layer 25 is located on a surface of the second electrode 27 that faces the liquid crystal panel 12. The first electrode 26 is located on a surface of the electroluminescent layer 25 that faces the liquid crystal panel 12 and functions as a cathode. The passivation film 28 is located on the sides of the electroluminescent layer 25, the first electrode 26, and the second electrode 27 and on a surface of the first electrode 26 that faces the liquid crystal panel 12.

The substrate 23 can be made of glass. The first electrode 26 is of a light transmittance type and can be made of indium tin oxide. The first electrode 26 can be made through deposition or sputtering. The second electrode 27 can be made of chromium. The second electrode 27 functions as a reflecting portion and reflects light that reaches the second electrode 27. The passivation film 28 is of a light transmittance type and can be made of silicon nitride, silicon oxide, or diamond-like carbon. The passivation film 28 blocks moisture, thereby sealing the electroluminescent layer 25. The first electrode 26, the second electrode 27, and the passivation film 28 are extremely thin compared to the substrate 23.

The first electrode 26 entirely covers a first surface of the electroluminescent layer 25, the surface that faces the liquid crystal panel 12. The second electrode 27 entirely covers a second surface of the electroluminescent layer 25, the surface that faces away from the liquid crystal panel 12.

The electroluminescent layer 25 includes an organic electroluminescent material and functions as the organic electroluminescent element. The electroluminescent layer 25 includes, for example, a hole injection layer, an illuminating layer, and an electron injection layer. Those layers are arranged in this order from the side facing the second electrode 27 toward the first electrode 26. When exposed to an electric field that is greater than a predetermined value, the electroluminescent layer 25 emits white light. The electroluminescent layer 25 is exposed to an electric field when voltage is applied to the first electrode 26 and the second electrode 27 by a drive apparatus, which is not shown.

A surface of the liquid crystal panel 12 that faces the backlight panel 13 (a surface of the polarizing plate 18 located facing away from the liquid crystal 16) and a surface of the liquid crystal panel 12 that faces the backlight panel 13 (a surface of the passivation film 28 facing away from the electroluminescent layer 25) are brought into intimate contact with each other.

An operation of the display 11 will now be described.

The display 11 operates in transmittance and reflectance modes. In the transmittance mode, the display 11 uses light emitted by the backlight panel 13 to show an image on the screen of the liquid crystal panel 12. In the reflectance mode, the display 11 uses the outside light to show an image on the screen.

In the transmittance mode, the backlight panel 13 is activated. When electricity is supplied to the backlight panel 13, voltage is applied to the first electrode 26 and the second electrode 27, which causes the electroluminescent layer 25 to emit white light. The emitted light exits from the light outputting surface and is irradiated onto the liquid crystal panel 12. Light that is irradiated onto portions of the liquid crystal panel 12 that correspond to liquid crystal elements permitting transmission of light passes through the liquid crystal 16. The passing through light is then converted into red light, green light, or blue light by the color filters 19. As a result, an image is shown on the screen of the liquid crystal panel 12.

In the reflectance mode, the backlight panel 13 is not activated. The outside light that is irradiated onto the display 11 reaches the second electrode 27. Then that light is reflected by the second electrode 27. The reflected light exits from the light outputting surface and is irradiated onto the liquid crystal panel 12. Light that is irradiated onto portions of the liquid crystal panel 12 that correspond to liquid crystal elements permitting transmission of light passes through the liquid crystal 16. The passing through light is then converted into red light, green light, or blue light by the color filters 19. As a result, an image is shown on the screen of the liquid crystal panel 12.

This embodiment provides the following advantages.

The passivation film 28 is located on the entire surface of the first electrode 26 that faces the liquid crystal panel 12. Therefore, even if the first electrode 26 has pinholes, moisture is prevented from entering the electroluminescent layer 25 through the pinholes. This prevents entry of moisture into the electroluminescent layer 25.

The electroluminescent layer 25 is closer to the light outputting surface than the substrate 23. Therefore, compared to a case where the substrate 23 is closer to the light outputting surface than the electroluminescent layer 25, light emitted by the electroluminescent layer 25 is less likely to be attenuated before passing through the light outputting surface. Also, since the first electrode 26 and the passivation film 28 are relatively thin, light emitted by the electroluminescent layer 25 is not significantly attenuated while passing through the first electrode 26 and the passivation film 28. This increases the amount of light that is outputted from the light outputting surface.

The first electrode 26 and the passivation film 28 are extremely thin compared to the substrate 23. Therefore, the distance between the liquid crystal panel 12 and the second electrode 27 is relatively short. This prevents an image shown on the screen of the liquid crystal panel 12 from appearing double. A double image is caused when an image shown on the screen is reflected by the second electrode 27.

The surface of the liquid crystal panel 12 facing the backlight panel 13 and the surface of the backlight panel 13 facing the liquid crystal panel 12 are in intimate contact. Therefore, compared to a case where the surface of the liquid crystal panel 12 facing the backlight panel 13 and the surface of the backlight panel 13 facing the liquid crystal panel 12 are not in intimate contact, the distance between the liquid crystal panel 12 and the second electrode 27 is short. This prevents an image shown on the screen from appearing double.

The backlight panel 13 includes only one organic electroluminescent element. That is, the backlight panel 13 includes only one first electrode 26 and only one second electrode 27. Compared to a case where the backlight panel 13 has two or more first electrodes 26 and two or more second electrodes 27, the backlight panel 13 has a simple structure.

Light emitted from the electroluminescent layer 25 toward the second electrode 27 is reflected by the second electrode 27 before being outputted from the light outputting surface. This increases the amount of light that is outputted from the light outputting surface.

The outside light that reaches the display 11 is reflected by the second electrode 27 and is outputted from the light outputting surface. This permits the display 11 to show an image on the screen using the outside light.

The second electrode 27 reflects light. Therefore, without providing a dedicated light reflecting member between the second electrode 27 and the substrate 23, light emitted from the electroluminescent layer 25 toward the second electrode 27 and outside light that reaches the display 11 are outputted through the light outputting surface.

It should be apparent to those skilled in the art that the present invention may be embodied in many other specific forms without departing from the spirit or scope of the invention. Particularly, it should be understood that the invention may be embodied in the following forms.

The transparent substrate 14, 15 are not necessarily made of glass, but may be made of resin.

The color filter 19 of the liquid crystal panel 12 may be omitted. In this case, a black and white image is shown on the screen of the liquid crystal panel 12.

The substrate 23 may be transparent or opaque, and may be made of resin, metal, or ceramic.

The electroluminescent layer 25 may include at least one of hole transport layer and an electron transport layer. Alternatively, the electroluminescent layer 25 may be. replaced by an electroluminescent layer having a light emitting layer and at least one of a hole injection layer, a hole transport layer, an electron transport layer, and an electron injection layer. Further, the hole injection layer and the electron injection layer of the electroluminescent layer 25 may be omitted. That is, the electroluminescent layer 25 may be replaced by an electroluminescent layer formed only of a light emitting layer.

The electroluminescent layer 25 may have a red light emitting layer, a blue light emitting layer, and a green light emitting layer.

The second electrode 27 may be made of a metal other than chromium. For example, the second electrode 27 may be made of an alloy that includes at least two of molybdenum, copper, and chromium; or it may be made of an alloy containing aluminum, palladium, and copper.

The liquid crystal panel 12 may be replaced by a semitransmissive liquid crystal panel. A semitransmissive liquid crystal panel includes a reflecting portion. Outside light that enters the liquid crystal panel through the screen is reflected by the reflecting portion toward the screen.

The second electrode 27 need not reflect light. That is, the second electrode 27 may be made of light transmitting material such as indium tin oxide. In this case, however, a dedicated member to reflect light is preferably located between the second electrode 27 and the substrate 23. Alternatively, the substrate 23 is preferably made of a light reflecting material.

Instead of the organic electroluminescent material, the electroluminescent layer 25 may contain an inorganic electroluminescent material.

The first electrode 26 may function as an anode, and the second electrode 27 may function as a cathode.

The surface of the liquid crystal panel 12 facing the backlight panel 13 and the surface of the backlight panel 13 facing the liquid crystal panel 12 need not be in intimate contact, but may be separated.

The present invention may be applied to a lighting system other than the backlight panel 13.

In addition to the first electrode 26, the electroluminescent layer 25, and the second electrode 27 on one side of the substrate 23, another set of the first electrode 26, the electroluminescent layer 25, and the second electrode 27 may be provided on the other side of the substrate 23.

The present examples and embodiments are to be considered as illustrative and not restrictive and the invention is not to be limited to the details given herein, but may be modified within the scope and equivalence of the appended claims.
A lighting system and a display prevent moisture from entering a light emitting element. The lighting system and a display of the present invention include an electroluminescent layer located between a first electrode and a second electrode. The electroluminescent layer functions as a light emitting element. A passivation film is located on the first electrode. The passivation film blocks moisture thereby sealing the electroluminescent layer.

## Claims

1. A lighting system, **characterized by:**
a substrate;
a light emitting element located on the substrate, wherein the light emitting element has a first surface and a second surface, wherein the first and second surfaces are on opposite sides of the light emitting element, wherein the second surface faces the substrate, and wherein the light emitting element contains an electroluminescent material;
a first electrode located on the first surface, wherein the first electrode is of a light transmittance type;
a second electrode located on the second surface, wherein, when a voltage is applied across the first electrode and the second electrode, the entire light emitting element emits light;
a passivation film located on the first electrode, wherein the passivation film is of a light transmittance type and covers the entire surface of the first electrode that faces away from the light emitting element; and
a light outputting surface located on the passivation film, wherein light emitted by the light emitting element is outputted from the light outputting surface.

2. The lighting system according to claim 1, **characterized in that** the light emitting element is formed as a sheet.

3. The lighting system according to claim 1 or 2, **characterized by** including a reflecting portion, wherein the reflecting portion faces the second surface and reflects light that reaches the reflecting portion.

4. The lighting system according to claim 3, **characterized in that** the second electrode functions as the reflecting portion.

5. The lighting system according to any one of claims 1 to 4, **characterized in that** the electroluminescent material is an organic material.

6. The lighting system according to any one of claims 1 to 4, **characterized in that** the electroluminescent material is an inorganic material.

7. The lighting system according to any one of claims 1 to 6, **characterized in that** the passivation film is made of silicon nitride, silicon oxide, or diamond-like carbon.

8. A display, **characterized by:**
a backlighting unit, wherein the backlighting unit includes:
a substrate;
a light emitting element located on the substrate, wherein the light emitting element has a first surface and a second surface, wherein the first and second surfaces are on opposite sides of the light emitting element, wherein the second surface faces the substrate, and wherein the light emitting element contains an electroluminescent material;
a first electrode located on the first surface, wherein the first electrode is of a light transmittance type;
a second electrode located on the second surface, wherein, when a voltage is applied across the first electrode and the second electrode, the entire light emitting element emits light;
a passivation film located on the first electrode, wherein the passivation film is of a light transmittance type and covers the entire surface of the first electrode that faces away from the light emitting element; and
a light outputting surface located on the passivation film, wherein light emitted by the light emitting element is outputted from the light outputting surface; and
a display unit located on the backlighting unit, wherein the display unit displays an image by using light outputted from the light outputting surface.

9. The display according to claim 8, **characterized in that** the display unit includes a plurality of liquid crystal elements.

10. The display according to claim 9, **characterized in that** the display unit is a transmissive liquid crystal unit or a semitransmissive liquid crystal unit.

11. The display according to any one of claims 8 to 10, **characterized in that** the light emitting element is formed as a sheet.

12. The display according to any one of claims 8 to 11, **characterized in that** the display unit is located on the light outputting surface.

13. The display according to claim 12, **characterized in that** the display unit is brought into intimate contact with the passivation film.

14. The display according to any one of claims 8 to 13, **characterized in that** the backlighting unit includes a reflecting portion, wherein the reflecting portion faces the second surface and reflects light that reaches the reflecting portion.

15. The display according to claim 14, **characterized in that** the second electrode functions as the reflecting portion.

16. The display according to any one of claims 8 to 15, **characterized in that** the electroluminescent material is an organic material.

17. The display according to any one of claims 8 to 15, **characterized in that** the electroluminescent material is an inorganic material.

18. The display according to any one of claims 8 to 17, **characterized in that** the passivation film is made of silicon nitride, silicon oxide, or diamond-like carbon.
